# EUROPEAN PATENT APPLICATION

(11) **EP 4 844 305 A1**
(43) Date of publication of application: **25.11.2026**
(21) Application number: 25742327.7
(22) Date of filing: 17.01.2025
(51) Int. Cl.: F25B 21/02, F28F 13/02, F28D 21/00

(54) **HEAT DISSIPATION DEVICE AND ELECTRONIC DEVICE COMPRISING SAME**

(30) Priority: 17.01.2024 KR 20240007450; 16.01.2025 KR 20250006475
(71) Applicant: KMW Inc., Hwaseong-si, Gyeonggi-do 18462 (KR)
(72) Inventor: JI, Kyo Sung, Hwaseong-si Gyeonggi-do 18484 (KR); CHOI, In Hwa, Yongin-si Gyeonggi-do 17148 (KR)
(74) Representative: Scheele, Friedrich
(86) International application number: PCT/KR2025/099082
(87) International publication number: WO 2025/155179

(57) **Abstract**

The present invention relates to a heat dissipation device and an electronic device comprising same. The heat dissipation device comprises: a housing body having a plurality of heat sink fins provided on the rear surface portion thereof; a heat dissipation unit formed on the front surface of the housing body and having a refrigerant flow space through which at least a phase changeable refrigerant flows; and a thermoelectric element having a heat-generating surface that is surface-contact bonded to the front portion of the heat dissipation unit, the heat-generating surface serving as a forward-facing bonding portion. Therefore, the heat dissipation device can improve the heat dissipation performance of the electronic device.

## Description

### [Technical Field]

The present disclosure relates to a heat dissipation device and an electronic device including the same, and more particularly, to a heat dissipation device capable of improving heat dissipation performance by more rapidly cooling heat from a heat-generating surface generated by a thermoelectric element using a phase-changeable refrigerant, and to an electronic device including the same.

### [Background Art]

A thermoelectric element using the Peltier effect is a semiconductor device in which heat is dissipated (heating occurs) at a forward-facing bonding portion and heat is absorbed (cooling occurs) at a reverse-facing bonding portion when an electric current is applied in one direction.

Since such a thermoelectric element can be implemented with low power consumption and in an ultra-compact size, it has been used in various small home appliance fields, such as compact refrigerators, cosmetic refrigerators, and wine refrigerators.

A conventional refrigerator using such a thermoelectric element is disclosed in Korean Patent Publication No. 10-2002-0069909.

However, the conventional refrigerator using the thermoelectric element has problems in that a heat dissipation area is very limited, a blowing fan for forcibly flowing air should be provided for rapid heat dissipation, thereby increasing power consumption and generating operating noise, and, since heat sink fins are cooled through the thermal conductivity of a material itself, such as aluminum, which generally has excellent thermal conductivity among metals, there is a very significant limitation in improving heat dissipation performance.

### [Disclosure]

### [Technical Problem]

The present disclosure is proposed to resolve the aforementioned technical issues and is directed to providing a heat dissipation device having greatly improved heat dissipation performance by utilizing, as a heat dissipation surface, an entire portion to which a heat-generating surface, which is a forward-facing bonding portion of a thermoelectric element, is coupled, and inducing active gas-liquid circulation through a phase change of a refrigerant, and an electronic device including the same.

In addition, the present disclosure provides a heat dissipation device capable of enabling a product to be manufactured in a slim form by minimizing a front-to-rear thickness of a housing body, and an electronic device including the same.

The present disclosure provides a heat dissipation device capable of preventing an increase in power consumption and operating noise since installation of an additional component, such as a separate blowing fan for promoting circulation of outside air, is unnecessary through securing excellent heat dissipation performance, and an electronic device including the same.

Technical issues of the present disclosure are not limited to the technical issues mentioned above, and other technical issues not mentioned above will be clearly understood by those skilled in the art from the following description.

### [Technical Solution]

A heat dissipation device according to an embodiment of the present disclosure includes a housing body having a plurality of heat sink fins provided on a rear surface thereof, a heat dissipation portion including a refrigerant flow space formed on a front surface of the housing body, through which at least a phase-changeable refrigerant flows, and a thermoelectric element having a heat-generating surface that is surface-contact coupled to a front portion of the heat dissipation portion, the heat-generating surface serving as a forward-facing bonding portion.

Here, the thermoelectric element may be disposed at a relatively lower intermediate portion of the front portion of the heat dissipation portion in the direction of gravity.

Further, the heat dissipation portion corresponding to a rear surface of the thermoelectric element may be machined to have a scribing portion configured to delay a flow of the refrigerant.

The heat dissipation portion may include a housing cover coupled to the housing body so as to cover the front portion of the refrigerant flow space, the housing cover having the scribing portion integrally formed on a rear surface thereof through machining.

The housing body and the housing cover may be made of an SUS material.

The heat dissipation portion may further include a refrigerant reservoir formed in the refrigerant flow space and configured to retain a liquid refrigerant condensed from the refrigerant and falling in the direction of gravity, and a refrigerant guide formed in the refrigerant flow space and configured to guide a flow of the liquid refrigerant toward the refrigerant reservoir.

The refrigerant reservoir may be provided within a front-to-rear directional region of the housing cover in which the scribing portion is formed.

The refrigerant guide may be formed to be inclined downward toward the refrigerant reservoir positioned relatively lower.

The refrigerant reservoir and the refrigerant guide each may be configured as a protruding panel having a predetermined thickness and a predetermined width such that each leading end thereof protrudes forward by a predetermined distance from an inner surface of the housing body corresponding to a rear portion of the refrigerant flow space.

The protruding panel may include a horizontal guide panel constituting the refrigerant reservoir, and an inclined guide panel constituting the refrigerant guide.

An amount by which the horizontal guide panel protrudes forward from the inner surface of the housing body may be greater than an amount by which the inclined guide panel protrudes forward.

The horizontal guide panel may be bent such that opposite ends of the protruding panel are positioned relatively upward so that a surface defining a front-to-rear width thereof blocks and retains the liquid refrigerant flowing in the direction of gravity.

The bent opposite ends of the horizontal guide panel may be connected to at least one of inclined guide panels.

A plurality of liquid refrigerant supply slits cut rearward so as to communicate with the scribing portion may be formed at a front end of the horizontal guide panel constituting the refrigerant reservoir.

The horizontal guide panel may be disposed horizontally in a left-right direction at a position corresponding to a portion where the scribing portion and the thermoelectric element are disposed, and may include an upper protruding panel positioned relatively upper and a lower protruding panel positioned relatively lower.

The inclined guide panel may be formed to be inclined downward from each of a left end and a right end of the inner surface of the housing body toward the horizontal guide panel.

The refrigerant guide may guide a flow of the liquid refrigerant from an upper end to a lower end of the inclined guide panel by a surface defining a front-to-rear thickness of the inclined guide panel.

The heat dissipation portion may further include a plurality of bonding portions formed in the refrigerant flow space and configured to bond the housing body to the rear surface of the housing cover.

The heat dissipation portion may further include a plurality of condensation protrusions formed in the refrigerant flow space and protruding to increase a surface area in thermal contact with gas refrigerant of the refrigerant.

At least some of the plurality of condensation protrusions may be formed on the inclined guide panel, and the remaining ones of the plurality of condensation protrusions may be formed on the inner surface of the housing body.

Front end surfaces of the plurality of condensation protrusions may be welded to the rear surface of the housing cover.

The scribing portion may include a plurality of grooves machined in the form of elongated grooves extending in a left-right horizontal direction on the rear surface of the housing cover, the plurality of grooves being spaced apart from one another in an up-down direction.

The scribing portion may include a plurality of grooves machined in the form of elongated grooves extending in an up-down vertical direction, the plurality of grooves being spaced apart from one another in a left-right direction.

An electronic device according to an embodiment of the present disclosure may include a casing body in which a low-temperature space for storing an article at a low temperature is formed, and a heat dissipation device including a thermoelectric element installed in the casing body, wherein a cooling surface, which is a reverse-facing bonding portion, is exposed toward the low-temperature space, and a heat-generating surface, which is a forward-facing bonding portion, is surface-contact coupled to a heat dissipation portion in which a refrigerant flow space through which a refrigerant flows is formed, and the heat dissipation device may include a housing body having a plurality of heat sink fins provided on a rear surface thereof, a heat dissipation portion including a refrigerant flow space formed on a front surface of the housing body, through which at least a phase-changeable refrigerant flows, and the thermoelectric element having a heat-generating surface that is surface-contact coupled to a front portion of the heat dissipation portion, the heat-generating surface serving as the forward-facing bonding portion.

A casing door configured to open and close the low-temperature space may be further provided at a front end of the casing body, and the housing body of the heat dissipation device may be installed so as to cover a rear end of the casing body.

The electronic device may further include a thermal insulation panel disposed between the low-temperature space of the casing body and the heat dissipation device, and the thermal insulation panel may be formed to have the same front-to-rear thickness as the thermoelectric element, and may be configured to support installation of the thermoelectric element such that the heat-generating surface, which is the forward-facing bonding portion of the thermoelectric element, is exposed toward the heat dissipation device, and the cooling surface, which is the reverse-facing bonding portion of the thermoelectric element, is exposed to the low-temperature space of the casing body.

### [Advantageous Effects]

According to a heat dissipation device according to an embodiment of the present disclosure and an electronic device including the same, various effects as follows may be achieved.

First, an effect of significantly improving heat dissipation performance may be achieved by inducing active gas-liquid circulation through a phase change of a refrigerant using heat generated from a heat-generating surface, which is a forward-facing bonding portion of a thermoelectric element.

Second, an effect of enabling a product to be manufactured in a slim form may be achieved by minimizing a front-to-rear thickness of a housing body.

Third, since heat can be effectively transferred and dissipated through a phase-changeable refrigerant, it is unnecessary to provide a separate blowing fan, thereby achieving an effect of preventing an increase in power consumption and additional generation of operating noise.

### [Description of Drawings]

FIG. 1 is an external perspective view illustrating an application example of a heat dissipation device and an electronic device including the same according to an embodiment of the present disclosure;
FIG. 2 is a perspective view illustrating the heat dissipation device according to an embodiment of the present disclosure;
FIGS. 3A and 3B are exploded perspective views of a front portion and a rear portion of FIG. 2, respectively;
FIG. 4 includes a front view (a), a plan view (b), and a side view (c) of FIG. 2;
FIGS. 5 and 6 are a front view of the configuration of FIG. 2 with a heat dissipation housing cover removed and a flow diagram illustrating a state change of a refrigerant, respectively;
FIG. 7 is a cross-sectional view taken along line A-A of FIG. 4 and a partially enlarged view thereof;
FIG. 8 is a perspective view illustrating an air circulation state of a tester for testing heat dissipation performance of the heat dissipation device according to an embodiment of the present disclosure;
FIG. 9 is a schematic view of thermoelectric elements according to a comparative example and the present disclosure; and
FIGS. 10A and 10B are graphs illustrating results obtained by the tester of FIG. 8.

### <Description of reference numerals>

| | | | |
|---|---|---|---|
| 1: | Electronic device | 100: | heat dissipation device |
| 110: | Housing body | 120: | air vent tube |
| 150: | Thermoelectric element | 200: | Heat dissipation portion |
| 205: | Refrigerant flow space | 210: | Refrigerant reservoir |
| 214, 215: | Protruding panels | 214: | Horizontal guide panel |
| 215: | Inclined guide panel | 216h: | Liquid refrigerant supply slit |
| 220: | Refrigerant guide | 230: | Refrigerant diffusion portion |
| 240: | Bonding portion | 250: | Condensation protrusion |
| 260: | Housing cover | 263: | Scribing portion |

### [Mode for Invention]

Hereinafter, a heat dissipation device and an electronic device including the same according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

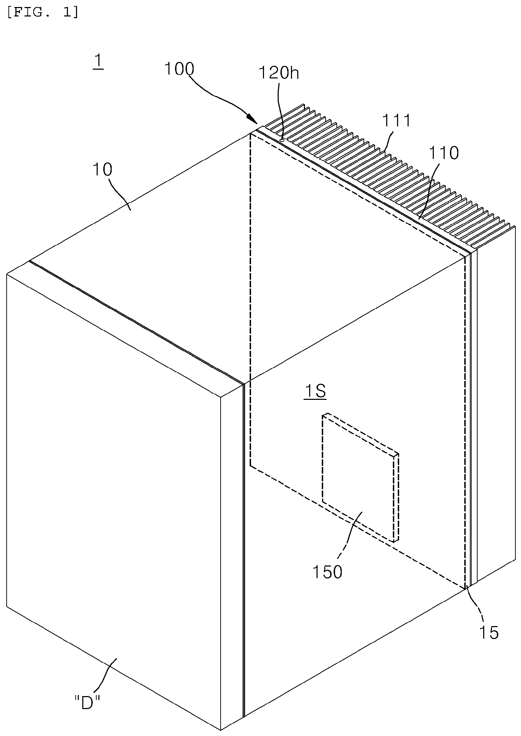

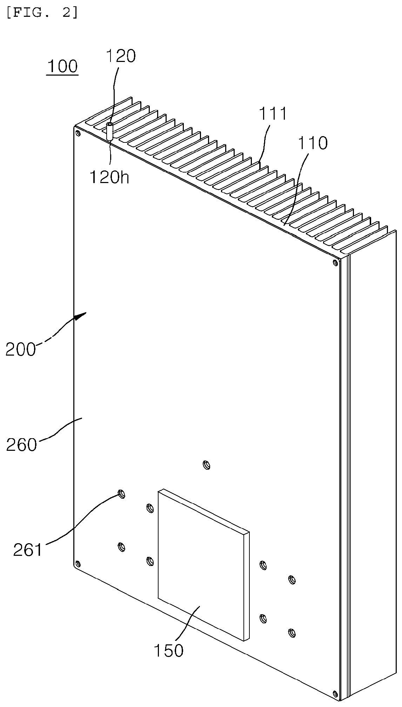

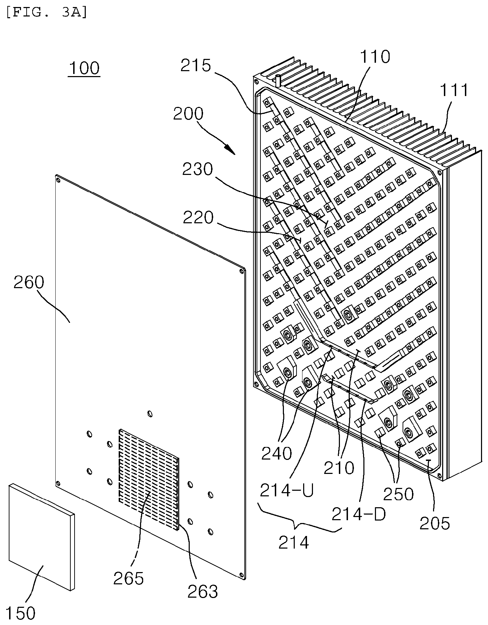

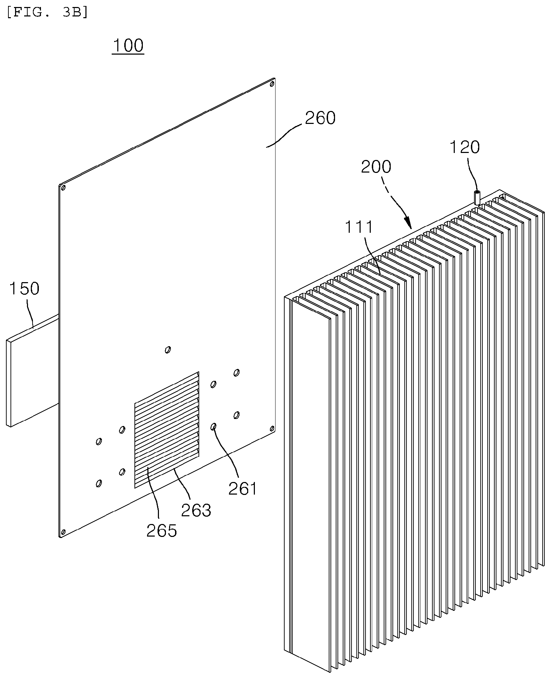

FIG. 1 is an external perspective view illustrating an application example of a heat dissipation device and an electronic device including the same according to an embodiment of the present disclosure, FIG. 2 is a perspective view illustrating the heat dissipation device according to an embodiment of the present disclosure, and FIGS. 3A and 3B are exploded perspective views of a front portion and a rear portion of FIG. 2, respectively

As shown in FIGS. 1 to 3B, an electronic device 1 according to an embodiment of the present disclosure may include a casing body 10 in which a low-temperature space 1S for storing an article requiring refrigerated or frozen storage at a low temperature is formed, a casing door D provided at a front end of the casing body 10 and configured to open and close the low-temperature space 1S of the casing body 10, and a heat dissipation device 100 installed at a rear end of the casing body 10 to dissipate heat generated from a heat-generating surface, which is a forward-facing bonding portion of a thermoelectric element 150 to be described later, toward a rear side of the casing body 10.

The low-temperature space 1S formed in the casing body 10 is a storage space for articles (food) that can be formed within the cooling performance limit of the thermoelectric element 150. Since the thermoelectric element 150 to be described later is generally implemented with low power consumption or in an ultra-compact size, it may mainly serve to store articles requiring refrigerated storage, such as beverages, cosmetics, or wine.

However, when the thermoelectric element 150 to be described later is implemented with high power or in a large size, it may also be configured such that food capable of being stored in a general refrigerator is stored therein.

Meanwhile, as shown in FIG. 1, the electronic device 1 according to an embodiment of the present disclosure may further include an insulation panel 15 disposed between the low-temperature space 1S of the casing body 10 and the heat dissipation device 100.

The insulation panel 15 is formed to have the same front-to-rear thickness as the thermoelectric element 150 to be described later, and serves to allow the thermoelectric element 150 to be installed such that the heat-generating surface, which is the forward-facing bonding portion of the thermoelectric element 150, is exposed toward the heat dissipation device 100 and the cooling surface, which is the reverse-facing bonding portion of the thermoelectric element 150, is exposed to the low-temperature space 1S of the casing body 10.

Here, as shown in FIGS. 2 to 3B, the heat dissipation device 100 and the electronic device 1 including the same according to an embodiment of the present disclosure may include the thermoelectric element 150 installed in the casing body 10 such that the cooling surface, which is the reverse-facing bonding portion, is exposed toward the low-temperature space 1S and the heat-generating surface, which is the forward-facing bonding portion, is surface-contact coupled to a heat dissipation portion 200 in which a refrigerant flow space 205 through which the refrigerant flows is formed.

More specifically, the heat dissipation device 100 according to an embodiment of the present disclosure may include a housing body 110 provided with a plurality of heat sink fins 111 on a rear surface thereof, the heat dissipation portion 200 including the refrigerant flow space 205 formed on a front surface of the housing body 110 and through which at least a phase-changeable refrigerant flows, and the above-described thermoelectric element 150 provided such that the heat-generating surface, which is the forward-facing bonding portion, is surface-contact coupled to a front portion of the heat dissipation portion 200.

Here, the plurality of heat sink fins 111 may be detachably coupled to the rear surface of the housing body 110. However, the plurality of heat sink fins are not necessarily detachably coupled, and may be integrally formed by molding together with the housing body during molding of the housing body 110.

That is, the heat-generating surface, which is the forward-facing bonding portion of the thermoelectric element 150, is disposed to face the rear side such that heat generated therefrom may be directly dissipated toward the rear side through the plurality of heat sink fins 111 integrally formed on the rear surface of the housing body 110, and the cooling surface, which is the reverse-facing bonding portion of the thermoelectric element 150, may be disposed to face the front side so as to cool air in the low-temperature space 1S located in front thereof.

Here, the housing body 110 may have the plurality of heat sink fins 111 integrally formed on the rear surface thereof, and the heat dissipation portion 200 formed on a front surface thereof in the shape of a box with a very small front-to-rear thickness and including the above-described refrigerant flow space 205.

The heat dissipation portion 200 may be a concept including all configurations related to gas-liquid circulation of the phase-changeable refrigerant filled in the refrigerant flow space 205 formed in the housing body 110.

The housing body 110 and the plurality of heat sink fins 111 integrally formed therewith may be made of a thermally conductive material capable of dissipating heat by exchanging heat with outside air (particularly, outside air at the rear side) through the thermal conductivity of the material itself.

In particular, the thermally conductive material constituting the housing body 110 and the plurality of heat sink fins 111 preferably includes a metal material, and may be made of either an aluminum (or aluminum alloy) material or an SUS (stainless steel) material. In general, in a heat dissipation mechanism in which heat is transferred only by the thermal conductivity of the material itself, it is preferable to selectively use an aluminum (or aluminum alloy) material. However, according to the present disclosure, in which a refrigerant is used as a heat transfer medium, the housing body 110 and a housing cover 260, which will be described later, may be formed of SUS (stainless steel) material, which is inexpensive and has excellent processability, insofar as they can be manufactured to be sufficiently thin to overcome the limitation of the thermal conductivity of the material itself in transferring heat to the refrigerant.

In addition, the refrigerant filled in the refrigerant flow space 205 of the heat dissipation portion 200 preferably selects a refrigerant having a boiling point (vaporization temperature) within a range suitable for a final cooling temperature of the low-temperature space 1S to be cooled, and more preferably may include a Honeywell refrigerant or water (including ultrapure water). In particular, water as the refrigerant is suitable when the metal material forming the refrigerant flow space 205 is an SUS material, and provides the advantage of minimizing a change in internal pressure of the refrigerant flow space 205 caused by a chemical reaction or the like occurring in the aluminum material and preventing environmental pollution due to leakage of the refrigerant in advance.

In the heat dissipation device 100 according to an embodiment of the present disclosure, the thermoelectric element 150 may be disposed at a relatively lower intermediate portion of the front portion of the heat dissipation portion 200 in the direction of gravity. This is because it is advantageous for a refrigerant in a liquid state condensed in the refrigerant flow space 205 (hereinafter, referred to as a "liquid refrigerant") to be collected in the direction of gravity and then undergo a phase change into a refrigerant in a gas state (hereinafter, referred to as a "gas refrigerant") by using heat supplied through the heat-generating surface, which is the forward-facing bonding portion of the thermoelectric element 150.

Meanwhile, the heat dissipation portion 200 may further include the housing cover 260 coupled to the housing body 110 so as to cover the front portion of the refrigerant flow space 205, and having a scribing portion 263 integrally machined on the rear surface thereof.

The scribing portion 263 may be formed in a shape recessed forward by a predetermined depth from the rear surface of the housing cover 260 provided in the form of a panel made of a thermally conductive metal material.

The scribing portion 263 may serve to stagnate or delay a flow, toward a lower side in the direction of gravity, of the liquid refrigerant condensed by exchanging heat through the heat sink fins 111 of the housing body 110 among refrigerants flowing through gas-liquid circulation within the refrigerant flow space 205.

In particular, the heat-generating surface, which is a forward-facing bonding portion of the thermoelectric element 150, may be attached to a front surface of the housing cover 260 in surface contact therewith. Preferably, the thermoelectric element 150 may be attached so as to be disposed at a lower end of the front surface of the housing cover 260, which is a portion in which the liquid refrigerant is mainly retained, and may be coupled so as to be disposed on the front surface of the housing cover 260 at a position corresponding to a portion where the scribing portion 263 is integrally formed.

Thus, when the scribing portion 263 receives heat from the heat-generating surface, which is the forward-facing bonding portion of the thermoelectric element 150, through the housing cover 260, the scribing portion serves to allow the liquid refrigerant to undergo the phase change into the gas refrigerant (i.e., evaporation) for a sufficient period of time by stagnating and delaying the flow of the liquid refrigerant.

Here, the scribing portion 263 may be formed in a shape in which a plurality of grooves in the form of lines 265 are combined. However, the scribing portion 263 may be precisely machined such that a plurality of lines 265 have the same dimensions and size by using a precision machining machine. Moreover, it is to be understood that, so long as the scribing portion 263 has a function of stagnating or delaying the flow of the liquid refrigerant, the scribing portion 263 may also be formed by creating a plurality of scratches using a sharp tool without precision machining.

In addition, a plurality of scribing portions 263 may be formed on the rear surface of the housing cover 260 to be spaced apart from one another in an upper and lower direction, and may be machined in the form of elongated grooves extending in a left and right horizontal direction on the rear surface of the housing cover 260. However, the formation direction of the scribing portions 263 is not limited to the left and right direction (i.e., a horizontal type). Rather, the plurality of scribing portions 263 may be formed on the rear surface of the housing cover 260 to be spaced apart from one another in a left and right direction, and may be machined in the form of elongated grooves extending in an upper and lower vertical direction (i.e., a vertical type) on the rear surface of the housing cover 260.

Although not shown in the drawings, as a result of a test conducted by the applicant of the present disclosure on the flowability of the liquid refrigerant according to the formation direction of the scribing portions 263, it was observed that, in the case of a horizontal type in which a plurality of lines 265 were formed in a left and right horizontal direction, the refrigerant spread leftward and rightward, fills the space without gaps, and then flows downward. This means that the liquid refrigerant is sequentially filled into the horizontally oriented scribing portions 263 positioned at upper locations and then into the horizontally oriented scribing portions 263 positioned at lower locations, and, while this process is repeated, the gas-liquid circulation cycle can be shortened to such an extent that the liquid refrigerant is completely phase-changed into the gas refrigerant before reaching the horizontally oriented scribing portion 263 formed closest to the lowermost portion.

On the other hand, in the case of the vertical type in which the plurality of lines 265 were formed in an upper and lower vertical direction, it was observed that the liquid refrigerant flowed downward easily. When the plurality of lines 265 are formed in such a vertical type, it is preferable that the vertical type be selectively applied when sufficient heat is supplied from the heat-generating surface of the thermoelectric element 150 so that circulation of the refrigerant can proceed rapidly.

As the amount of the liquid refrigerant stagnated or delayed by the scribing portion 263 having such a function increases, the amount of the refrigerant evaporated by heat supplied from the heat-generating surface of the thermoelectric element 150 may be promoted.

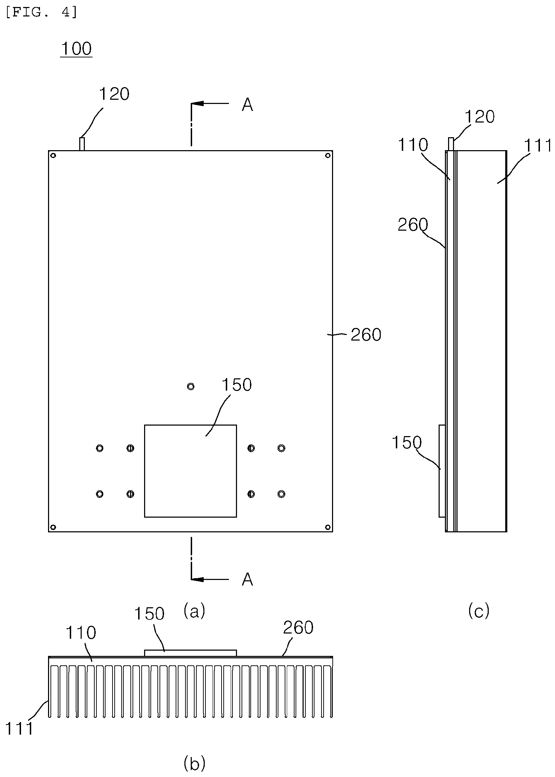

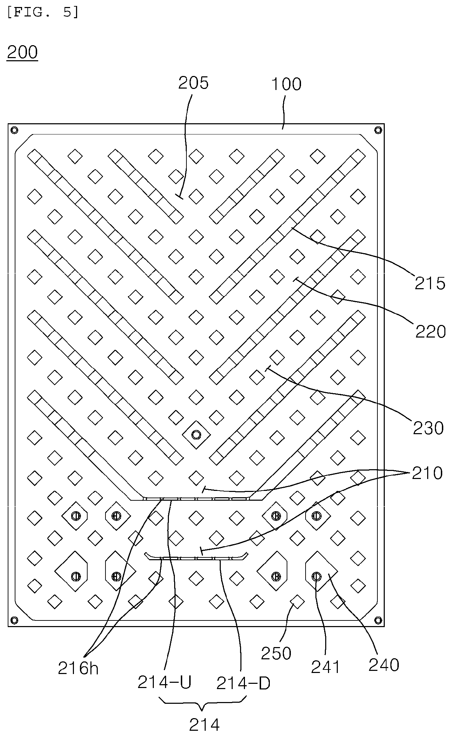

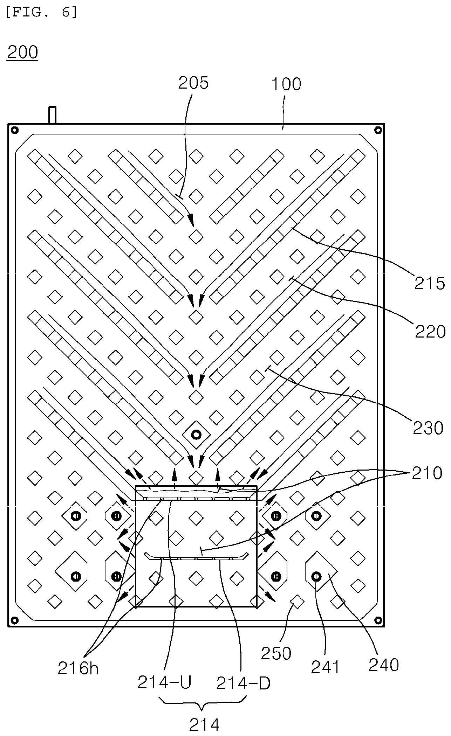

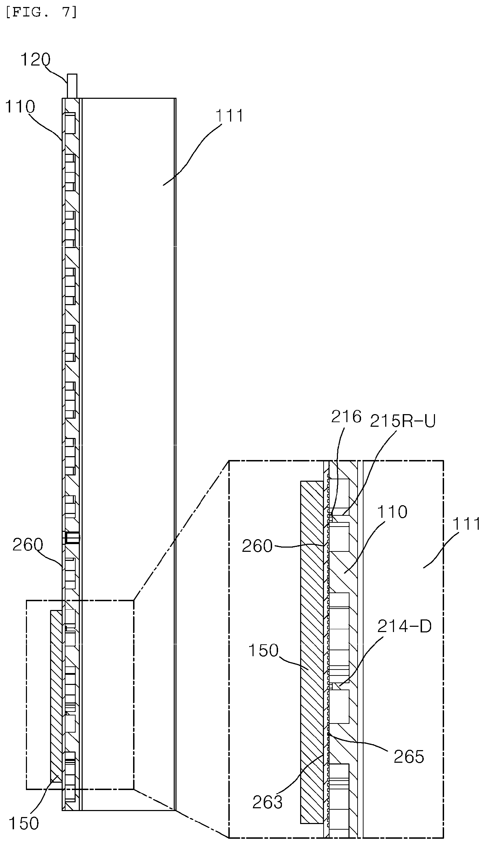

FIGS. 5 and 6 are a front view of the configuration of FIG. 2 with a heat dissipation housing cover removed and a flow diagram illustrating a state change of a refrigerant, respectively, and FIG. 7 is a cross-sectional view taken along line A-A of FIG. 4 and a partially enlarged view thereof.

As shown in FIGS. 5 to 7, the heat dissipation portion 200 may include a refrigerant reservoir 210 formed in the refrigerant flow space 205 and configured to retain a liquid refrigerant condensed from the refrigerant and falling in the direction of gravity, a refrigerant guide 220 formed in the refrigerant flow space 205 and configured to guide the flow of the liquid refrigerant toward the refrigerant reservoir 210, and a refrigerant diffusion portion 230 providing a space through which a gas refrigerant evaporated from the refrigerant reservoir 210 among the refrigerant flows and diffuses.

The refrigerant reservoir 210 may be formed at a position corresponding to a portion where the above-described scribing portion 263 and thermoelectric element 150 are disposed. Preferably, the refrigerant reservoir 210 may be provided within a front-to-rear directional region of the housing cover 260 in which the scribing portion 263 is formed.

Here, the refrigerant guide 220 may be formed to be inclined downward toward the refrigerant reservoir 210 positioned relatively lower. For example, when the refrigerant reservoir 210 is positioned at a relatively lower intermediate portion of the front portion of the housing body 110, the refrigerant guide 220 may be formed to be inclined downward from a left end and a right end of the housing body 110 toward an intermediate portion of the housing body 110, respectively.

In particular, the refrigerant reservoir 210 and the refrigerant guide 220 may be configured as protruding panels 214 and 215 having predetermined thicknesses and predetermined widths such that respective leading ends thereof protrude forward by predetermined distances from an inner surface of the housing body 110 corresponding to a rear portion of the refrigerant flow space 205.

Here, the protruding panels 214 and 215 may be provided in the form of panels extending in a longitudinal direction and having predetermined thicknesses and predetermined widths. Hereinafter, the "width" of each of the protruding panels 214 and 215 refers to a portion greater than the "thickness" thereof, the refrigerant reservoir 210 may be disposed such that a surface defining the thickness is in contact with the inner surface of the refrigerant flow space 205, and the refrigerant guide 220 may be disposed such that a surface defining the width is in contact with the inner surface of the refrigerant flow space 205.

More specifically, the protruding panels 214 and 215 may include a horizontal guide panel 214 formed horizontally to define the refrigerant reservoir 210, and an inclined guide panel 215 formed to be inclined so as to define the refrigerant guide 220.

The horizontal guide panel 214 constituting the refrigerant reservoir 210 among the protruding panels 214 and 215 may be disposed such that a surface defining the thickness thereof is in contact with the refrigerant flow space 205 so as to retain and store a greater amount of the liquid refrigerant.

In addition, the inclined guide panel 215 constituting the refrigerant guide 220 among the protruding panels 214 and 215 may guide the flow of the liquid refrigerant flowing down along the inner surface of the housing body 110 from an upper end thereof to a lower end thereof by a surface defining the front-to-rear thickness. Here, since it is sufficient for the inclined guide panel 215 to guide the flow of the liquid refrigerant through the surface thereof, a surface defining the width may be in contact with the refrigerant flow space 205.

Accordingly, an amount by which the horizontal guide panel 214 constituting the refrigerant reservoir 210 protrudes forward from the inner surface of the housing body 110 may be greater than an amount by which the inclined guide panel 215 constituting the refrigerant guide 220 protrudes forward.

In particular, the refrigerant reservoir 210 may be formed such that opposite ends of the horizontal guide panel 214 are bent to be positioned relatively upward so that a surface defining the front-to-rear width of the horizontal guide panel 214 blocks the liquid refrigerant flowing in the direction of gravity and retains the liquid refrigerant for a predetermined period of time. Here, the opposite ends of the horizontal guide panel 214 may be connected to at least one of the inclined guide panels 215.

Such horizontal guide panels 214 may be formed such that at least two horizontal guide panels are spaced apart from each other in an upper and lower direction within a range in which areas occupied by the above-described scribing portion 263 and the thermoelectric element 150 overlap in the front-to-rear direction (see reference numerals "214-U" and "214-D" in FIGS. 5 and 6). That is, the horizontal guide panels 214 may be disposed horizontally in a left and right direction at positions corresponding to portions where the scribing portion 263 and the thermoelectric element 150 are disposed, and may include an upper protruding panel 214-U positioned relatively upward and a lower protruding panel 214-D positioned relatively downward.

Here, a front end of the horizontal guide panel 214 is disposed in close contact with the rear surface of the housing cover 260, and the horizontal guide panel may be cut rearward to form a plurality of liquid refrigerant supply slits 216h so as to communicate with the refrigerant reservoir 210 and the scribing portion 263.

Since the liquid refrigerant guided by the refrigerant guide 220 and flowing downward may flow into the scribing portion 263 through the plurality of liquid refrigerant supply slits 216h, the liquid refrigerant condensed over the entire region of the refrigerant flow space 205 may be continuously supplied to the scribing portion 263. In addition, the inclined guide panels 215, which are protruding panels constituting the refrigerant guide 220, may be formed to be inclined downward from the left end and the right end toward a central portion, respectively, on the inner surface of the housing body 110.

The refrigerant guide 220 may guide the flow of the liquid refrigerant from an upper end thereof to a lower end thereof by a surface defining the thickness of the inclined guide panels 215, and thus serves to collect the liquid refrigerant condensed throughout the entire region of the refrigerant flow space 205 toward a portion where the scribing portion 263 and the thermoelectric element 150 are located.

Meanwhile, as shown in FIGS. 5 to 7, the heat dissipation portion 200 may further include a plurality of bonding portions 240 formed in the refrigerant flow space 205 and bonded to the rear surface of the housing cover 260.

The plurality of bonding portions 240 are formed in the shape of protrusions in the refrigerant flow space 205, and respective bonding-portion receiving holes 241 to be coupled to the housing cover 260 through welding by any one of various welding methods including a laser welding method may be formed through bonding-portion holes 261 formed in the housing cover 260.

In addition, the housing cover 260 may further be provided with bonding-portion holes 261 penetrating in the front-to-rear direction at positions corresponding to the bonding-portion receiving holes 241 for the above-described welding.

Meanwhile, the heat dissipation portion 200 may further include a plurality of condensation protrusions 250 formed in the refrigerant flow space 205 and protruding for thermal contact with the gas refrigerant among the refrigerant.

As shown in FIGS. 5 to 7, the plurality of condensation protrusions 250 are disposed to protrude substantially to an extent that they are in contact with the rear surface of the housing cover 260 covering a front portion of the refrigerant flow space 205. Some of the condensation protrusions may be formed on the inclined guide panels 215 among the protruding panels constituting the refrigerant guide 220, and the remaining condensation protrusions 250 may be formed in plurality on the inner surface of the housing body 110 at portions independent of the refrigerant guide 220.

The plurality of condensation protrusions 250 may serve to shorten a gas-liquid circulation cycle time by increasing a thermal contact surface area while causing flow interference when the gas refrigerant vaporized in the refrigerant flow space 205 diffuses and flows through the refrigerant diffusion portion 230.

Here, the front end surfaces of the plurality of condensation protrusions 250 may also be welded to the rear surface of the housing cover 260.

In addition, an air vent tube 120 may be coupled to the upper end of the housing body 110 so as to communicate with the refrigerant flow space 205.

The air vent tube 120 may be provided in a tube connection hole 120h of the housing body 110, and may be formed in the shape of a tube to which a vacuuming tool or a refrigerant charging tool, not shown, is connectable during a vacuuming process of the refrigerant flow space 205 or during refrigerant charging.

Here, when the above-described vacuuming process or refrigerant charging is completed, the air vent tube 120 may seal the refrigerant flow space 205 through a caulking finishing process after a portion thereof exposed to an outer side of the tube connection hole 120h is cut off and removed.

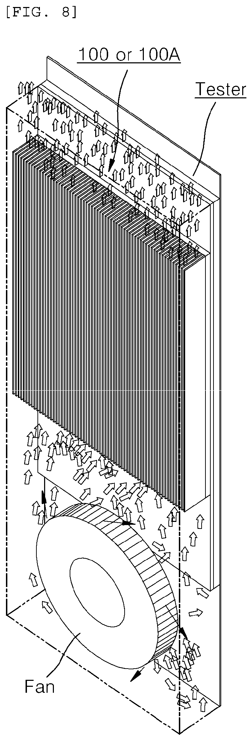

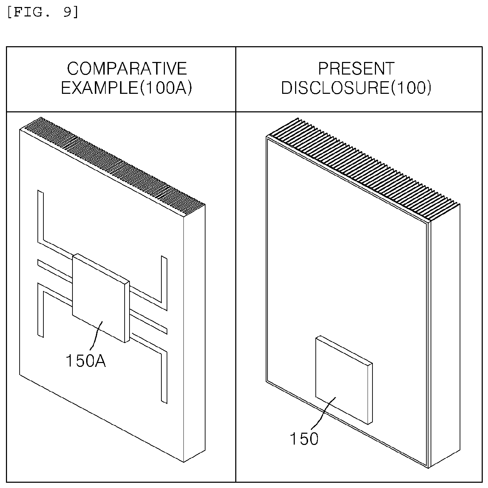

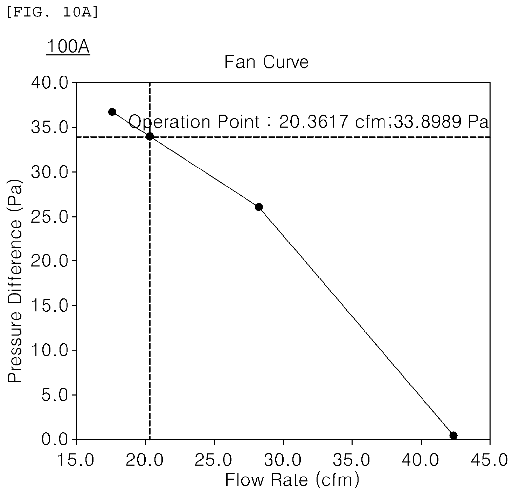

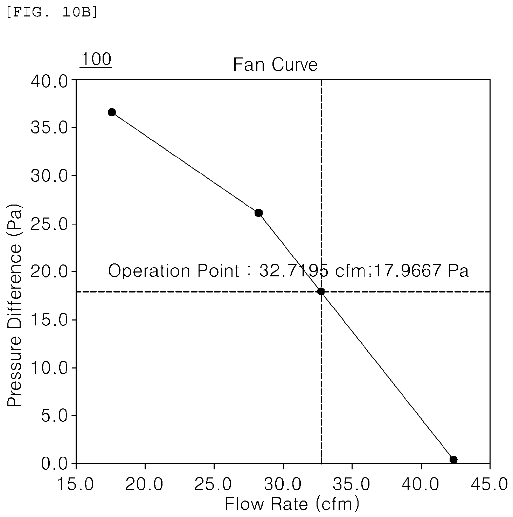

FIG. 8 is a perspective view illustrating an air circulation state of a tester for testing heat dissipation performance of the heat dissipation device according to an embodiment of the present disclosure, FIG. 9 is a schematic view of thermoelectric elements according to a comparative example 100A and the present disclosure 100, and FIGS. 10A and 10B are graphs illustrating results obtained by the tester of FIG. 8.

In order to compare and verify the heat dissipation performance of the heat dissipation device 100 according to an embodiment of the present disclosure configured as described above, a thermoelectric element 150A of Comparative Example 100A as shown in FIG. 9 was provided, and the results shown in FIGS. 10A and 10B were respectively obtained.

More specifically, in Comparative Example 100A and the present disclosure 100, the housing body 110 had the same width and height, with dimensions of 186.0 × 250.0 (unit: mm). However, the front-to-rear thickness including the heat sink fins 111 was 26.0 (unit: mm) in Comparative Example 100A and 40.0 (unit: mm) in the present disclosure 100. In addition, the total number of heat sink fins 111 was 61 in Comparative Example 100A, whereas 40 heat sink fins 111 were employed in the present disclosure 100.

As shown in FIG. 8, after the housing body 110 of Comparative Example 100A and that of the present disclosure 100 were attached to the same tester, a forced airflow was generated upward by a predetermined blowing force using a blowing fan disposed at a lower side, and the measured temperature value and the flow rate of the liquid refrigerant were confirmed in terms of volumetric flow rate (CFM).

As a result, the temperature value of Comparative Example 100A was 39°C, whereas the temperature value of the present disclosure 100 was 32.3°C, which was approximately 6.7°C lower. In addition, as shown in FIGS. 10A and 10B, it was confirmed that, although the number of heat sink fins 111 in the present disclosure 100 was 21 fewer than that in Comparative Example 100A, the refrigerant flow rate (CFM) was 32.7, which was 12.3 higher than that of Comparative Example 100A.

This indicates that the heat dissipation by the heat dissipation portion 200 of the present disclosure 100, which has a heat dissipation structure based on gas-liquid circulation of the refrigerant (particularly, water as the refrigerant filled between the housing body 110 and the housing cover 260 made of an SUS material), is superior to that in a case where gas-liquid circulation of the phase-changeable refrigerant is not used, thereby further improving the heat dissipation performance.

In particular, by forming the scribing portion 263 on the housing cover 260, which directly receives heat from the thermoelectric element 150 among the components of the heat dissipation portion 200, the flow of the liquid refrigerant in a portion corresponding to an evaporation region can be somewhat stagnated (delayed), thereby inducing active gas-liquid circulation.

The electronic device 1 according to an embodiment of the present disclosure configured as described above may further include the casing door D provided at a front end of the casing body 10, as shown in FIG. 1.

Accordingly, the casing body 10 is formed in the shape of a rectangular parallelepiped having front and rear openings, wherein the front opening is configured to be opened and closed by the casing door D, and the rear opening may be provided with the heat dissipation device 100 according to an embodiment of the present disclosure to seal the low-temperature space 1S, the heat dissipation device being configured to rapidly dissipate heat generated from the heat-generating surface of the thermoelectric element 150.

According to the heat dissipation device 100 according to an embodiment of the present disclosure configured as described above and the electronic device 1 including the same, an advantage is provided in that the limitation of the heat dissipation performance that simply depends on the thermal conductivity of the material itself of the heat sink fins 111 can be overcome, and the heat dissipation performance can be maximized by rapidly increasing the number of gas-liquid circulation cycles of the refrigerant therein.

As described above, a heat dissipation device and an electronic device including the same according to embodiments of the present disclosure have been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

## Claims

1. A heat dissipation device, comprising:
a housing body having a plurality of heat sink fins provided on a rear surface thereof;
a heat dissipation portion including a refrigerant flow space formed on a front surface of the housing body, through which at least a phase-changeable refrigerant flows; and
a thermoelectric element having a heat-generating surface that is surface-contact coupled to a front portion of the heat dissipation portion, the heat-generating surface serving as a forward-facing bonding portion.

2. The heat dissipation device of claim 1, wherein the thermoelectric element is disposed at a relatively lower intermediate portion of the front portion of the heat dissipation portion in the direction of gravity.

3. The heat dissipation device of claim 2, wherein the heat dissipation portion corresponding to a rear surface of the thermoelectric element is machined to have a scribing portion configured to delay a flow of the refrigerant.

4. The heat dissipation device of claim 3, wherein the heat dissipation portion comprises:
a housing cover coupled to the housing body so as to cover the front portion of the refrigerant flow space, the housing cover having the scribing portion integrally formed on a rear surface thereof through machining.

5. The heat dissipation device of claim 4, wherein the housing body and the housing cover are made of an SUS material.

6. The heat dissipation device of claim 4, wherein the heat dissipation portion further comprises:
a refrigerant reservoir formed in the refrigerant flow space and configured to retain a liquid refrigerant condensed from the refrigerant and falling in the direction of gravity; and
a refrigerant guide formed in the refrigerant flow space and configured to guide a flow of the liquid refrigerant toward the refrigerant reservoir.

7. The heat dissipation device of claim 6, wherein the refrigerant reservoir is provided within a front-to-rear directional region of the housing cover in which the scribing portion is formed.

8. The heat dissipation device of claim 7, wherein the refrigerant guide is formed to be inclined downward toward the refrigerant reservoir positioned relatively lower.

9. The heat dissipation device of claim 6, wherein the refrigerant reservoir and the refrigerant guide each are configured as a protruding panel having a predetermined thickness and a predetermined width such that each leading end thereof protrudes forward by a predetermined distance from an inner surface of the housing body corresponding to a rear portion of the refrigerant flow space.

10. The heat dissipation device of claim 9, wherein the protruding panel comprises:
a horizontal guide panel constituting the refrigerant reservoir; and
an inclined guide panel constituting the refrigerant guide.

11. The heat dissipation device of claim 10, wherein an amount by which the horizontal guide panel protrudes forward from the inner surface of the housing body is greater than an amount by which the inclined guide panel protrudes forward.

12. The heat dissipation device of claim 10, wherein the horizontal guide panel is bent such that opposite ends thereof are positioned relatively upward so that a surface defining a front-to-rear width thereof blocks and retains the liquid refrigerant flowing in the direction of gravity.

13. The heat dissipation device of claim 12, wherein the bent opposite ends of the horizontal guide panel are connected to at least one of inclined guide panels.

14. The heat dissipation device of claim 12, wherein a plurality of liquid refrigerant supply slits cut rearward so as to communicate with the scribing portion are formed at a front end of the horizontal guide panel constituting the refrigerant reservoir.

15. The heat dissipation device of claim 10, wherein the horizontal guide panel is disposed horizontally in a left-right direction at a position corresponding to a portion where the scribing portion and the thermoelectric element are disposed, and comprises an upper protruding panel positioned relatively upper and a lower protruding panel positioned relatively lower.

16. The heat dissipation device of claim 10, wherein the inclined guide panel is formed to be inclined downward from each of a left end and a right end of the inner surface of the housing body toward the horizontal guide panel.

17. The heat dissipation device of claim 16, wherein the refrigerant guide guides a flow of the liquid refrigerant from an upper end to a lower end of the inclined guide panel by a surface defining a front-to-rear thickness of the inclined guide panel.

18. The heat dissipation device of claim 6, wherein the heat dissipation portion further comprises:
a plurality of bonding portions formed in the refrigerant flow space and configured to bond the housing body to the rear surface of the housing cover.

19. The heat dissipation device of claim 6, wherein the heat dissipation portion further comprises:
a plurality of condensation protrusions formed in the refrigerant flow space and protruding to increase a surface area in thermal contact with gas refrigerant of the refrigerant.

20. The heat dissipation device of claim 19, wherein at least some of the plurality of condensation protrusions are formed on the inclined guide panel, and the remaining ones of the plurality of condensation protrusions are formed on the inner surface of the housing body.

21. The heat dissipation device of claim 19, wherein front end surfaces of the plurality of condensation protrusions are welded to the rear surface of the housing cover.

22. The heat dissipation device of claim 3, wherein the scribing portion comprises a plurality of grooves machined in the form of elongated grooves extending in a left-right horizontal direction on the rear surface of the housing cover, the plurality of grooves being spaced apart from one another in an up-down direction.

23. The heat dissipation device of claim 3, wherein the scribing portion comprises a plurality of grooves machined in the form of elongated grooves extending in an up-down vertical direction, the plurality of grooves being spaced apart from one another in a left-right direction.

24. The heat dissipation device of claim 1, wherein the plurality of heat sink fins are detachably coupled to the rear surface of the housing body.

25. The heat dissipation device of claim 1, wherein the plurality of heat sink fins are integrally formed on the rear surface of the housing body.

26. An electronic device, comprising:
a casing body in which a low-temperature space for storing an article at a low temperature is formed; and
a heat dissipation device including a thermoelectric element installed in the casing body, wherein a cooling surface, which is a reverse-facing bonding portion, is exposed toward the low-temperature space, and a heat-generating surface, which is a forward-facing bonding portion, is surface-contact coupled to a heat dissipation portion in which a refrigerant flow space through which a refrigerant flows is formed,
wherein the heat dissipation device comprises:
a housing body having a plurality of heat sink fins provided on a rear surface thereof;
a heat dissipation portion including a refrigerant flow space formed on a front surface of the housing body, through which at least a phase-changeable refrigerant flows; and
the thermoelectric element having a heat-generating surface that is surface-contact coupled to a front portion of the heat dissipation portion, the heat-generating surface serving as the forward-facing bonding portion.

27. The electronic device of claim 26, wherein a casing door configured to open and close the low-temperature space is further provided at a front end of the casing body, and
the housing body of the heat dissipation device is installed so as to cover a rear end of the casing body.

28. The electronic device of claim 26, further comprising:
a thermal insulation panel disposed between the low-temperature space of the casing body and the heat dissipation device,
wherein the thermal insulation panel is formed to have the same front-to-rear thickness as the thermoelectric element, and is configured to support installation of the thermoelectric element such that the heat-generating surface, which is the forward-facing bonding portion of the thermoelectric element, is exposed toward the heat dissipation device, and the cooling surface, which is the reverse-facing bonding portion of the thermoelectric element, is exposed to the low-temperature space of the casing body.
